# FASCICULE DE BREVET EUROPEEN

(11) **EP 2 194 626 B1**
(45) Date de publication et mention de la délivrance du brevet: **07.12.2011**
(21) Numéro de dépôt: 09290849.0
(22) Date de dépôt: 09.11.2009
(51) Int. Cl.: H02G 3/14

(54) **Plaque d'habillage pour appareillage électrique**
Verkleidungsplatte für Elektrogerät
Covering plate for an electrical device

(30) Priorité: 02.12.2008 FR 0806763
(43) Date de publication de la demande: 09.06.2010
(73) Titulaire: Legrand France, 87000 Limoges (FR); Legrand SNC, 87000 Limoges (FR)
(72) Inventeur: Chaumeny, Jean-Luc, 87110 Solignac (FR); Petit, Laurent, 87260 Saint Hilaire Bonneval (FR); Toulemonde, Denys, 87570 Rilhac-Rancon (FR)
(74) Mandataire: Orsini, Fabienne

(56) Documents cités:
- JP-A- 60 009 312
- JP-U- 57 078 214

## Description

La présente invention concerne de manière générale les appareillages électriques.

Elle concerne plus particulièrement une plaque d'habillage pour appareillage électrique selon les caractéristiques du préambule de la revendication 1.

Elle concerne également un appareillage électrique comportant un support d'appareillage qui supporte un mécanisme d'appareillage présentant en face avant au moins une partie fonctionnelle et sur lequel est montée une plaque d'habillage telle que précitée.

### ARRIÈRE-PLAN TECHNOLOGIQUE

Généralement, dans les plaques d'habillage déjà connues, la plaque avant de finition et la plaque arrière de montage présentent des dimensions similaires de sorte qu'elles se superposent pratiquement parfaitement.

Ainsi, c'est la superposition de la plaque de finition et de la plaque de montage qui donne l'épaisseur de la plaque d'habillage. L'épaisseur de la plaque de finition variant en fonction du matériau de finition dans lequel elle est réalisée, actuellement, pour chaque matériau de finition l'on obtient une épaisseur de plaque d'habillage différente.

En outre, dans ces plaques d'habillage, la plaque de finition doit être réalisée avec le plus grand soin afin, d'une part, d'éviter qu'apparaissent sur son bord extérieur visible des défauts inacceptables comme des bavures, des brûlures ou encore des ébréchures, et, d'autre part, de s'assurer que son bord intérieur, qui délimite chaque ouverture de la plaque de finition, s'ajuste au mieux autour de chaque partie fonctionnelle de l'appareillage électrique. Le coût de fabrication de ces plaques s'avère alors relativement élevé.

On connaît par ailleurs du document JP 60 009312 une plaque d'habillage pour appareillages électriques, dont la plaque de montage comporte un rebord périphérique en saillie sur sa face avant, de manière à former un logement pour accueillir la plaque de finition. Bien que protégée sur son bord extérieur par ce rebord périphérique, la plaque de finition n'est toutefois pas protégée sur son bord intérieur, si bien qu'elle reste exposée lors des mouvements de la partie fonctionnelle de l'appareillage électrique. Par ailleurs, la plaque de finition doit être réalisée avec le plus grand soin afin de s'assurer que son bord intérieur s'ajuste au mieux autour de chaque partie fonctionnelle de l'appareillage électrique, ce qui s'avère onéreux.

### OBJET DE L'INVENTION

Afin de remédier aux inconvénients de l'état de la technique, la présente invention propose une plaque d'habillage dont l'épaisseur est identique quel que soit le matériau de finition utilisé, dont le poids peut être relativement élevé pour donner une impression de grande qualité à l'utilisateur, qui s'affranchit des problèmes de défauts de tranche de la plaque de finition, qui est simple à mettre en oeuvre et que l'on peut faire évoluer très facilement.

Plus particulièrement, on propose selon l'invention une plaque d'habillage selon les caractéristiques de la revendication 1.

Ainsi, grâce à l'invention, la plaque avant de finition peut être réalisée dans un matériau plus agréable à l'oeil et au toucher que le matériau utilisé pour la plaque arrière de finition.

Il sera en particulier possible de réaliser la plaque avant de finition dans un matériau onéreux sans pour autant modifier de manière conséquente le coût global de la plaque d'habillage.

Il sera en outre possible de réaliser cette plaque avant de finition dans un matériau difficile à dimensionner, sans que les éventuels défauts de dimensionnement ne nuisent à l'esthétisme de la plaque d'habillage. La plaque arrière de montage sera à cet effet réalisée dans un matériau plus aisé à dimensionner, et recouvrira la tranche de la plaque avant de finition, de manière à cacher les éventuels défauts que cette plaque avant de finition pourrait présenter.

Par ailleurs, la plaque arrière de montage étant préférentiellement réalisée dans un matériau différent de celui de la plaque avant de finition, elle pourra être réalisée dans un matériau plus lourd que celui de la plaque avant de finition, de manière à conférer à l'utilisateur un sentiment de qualité.

D'autres caractéristiques avantageuses et non limitatives de la plaque d'habillage conforme à l'invention sont énumérées dans les revendications 2 à 13.

L'invention concerne également un appareillage électrique selon les caractéristiques de la revendication 14.

### DESCRIPTION DÉTAILLÉE D'UN EXEMPLE DE RÉALISATION

La description qui va suivre, en regard des dessins annexés, donnée à titre d'exemple non limitatif, fera bien comprendre en quoi consiste l'invention et comment elle peut être réalisée.

Sur les dessins annexés :
- la figure 1 est une vue éclatée d'un premier mode de réalisation d'un appareillage électrique selon l'invention ;
- la figure 2 est une vue de détail de la zone Il de la figure 1 ;
- la figure 3 est une vue en perspective arrière de la sous-plaque de la figure 1 ;
- la figure 4 est une vue de détail de la zone IV de la figure 3 ;
- la figure 5 est une vue en perspective assemblée de la plaque d'habillage de la figure 1 ;
- la figure 6 est une vue en coupe selon le plan A-A de la figure 5 ;
- la figure 7 est une vue en perspective de la sous-plaque et de la plaque intermédiaire de la figure 1, en position assemblée ;
- les figures 8 et 9 sont des schémas d'assemblage de la sous-plaque avec la plaque intermédiaire, représentant en détail la zone VIII de la figure 7 ;
- la figure 10 est une vue en perspective éclatée d'un second mode de réalisation de la sous-plaque et de la plaque intermédiaire de la plaque d'habillage selon l'invention ;
- la figure 11 est une vue éclatée d'un troisième mode de réalisation de la plaque d'habillage de la figure 1 ;
- la figure 12 est une vue en perspective assemblée de la plaque d'habillage de la figure 11 ; et
- la figure 13 est une vue en coupe selon le plan B-B de la figure 12.

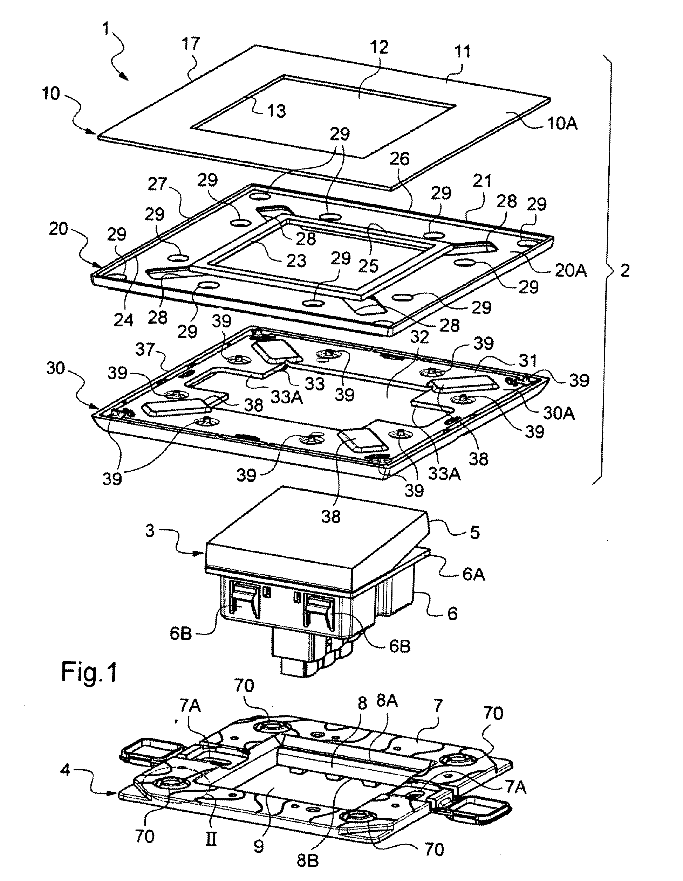

Sur la figure 1, on a représenté en éclaté un appareillage électrique 1 qui comprend un support d'appareillage 4, ainsi qu'un mécanisme d'appareillage 3 et une plaque d'habillage 2 montés sur ce support d'appareillage 4.

Le support d'appareillage 4 présente ici la forme d'un cadre 7 plat de forme carrée, qui comporte une âme réalisée en matière métallique surmoulée d'une peau en matière synthétique isolante.

Ce cadre 7 présente un bord intérieur 8 qui délimite une ouverture centrale 9 également carrée, pour accueillir le mécanisme d'appareillage 3.

Il comporte en outre, au milieu de deux branches opposées, deux perçages 7A de formes oblongues pour la fixation du support d'appareillage 4 sur une boîte (non représentée) encastrée dans une paroi ou à rapporter en saillie sur une telle paroi. Chacun de ces deux perçages 7A est destiné à venir en regard d'un fût tubulaire ménagé dans ladite boîte pour accueillir le corps fileté d'une vis de fixation.

Ce support d'appareillage 4 permet ainsi d'immobiliser le mécanisme d'appareillage 3 dans ladite boîte.

Le mécanisme d'appareillage 3 comporte en l'espèce un socle 6 en matière isolante qui est ouvert en face avant et qui loge intérieurement des bornes de connexion électrique non représentées. Le socle 6 est fermé à l'avant par la partie fonctionnelle 5 de l'appareillage électrique.

Ici, l'appareillage électrique 1 présente une fonction d'interrupteur et la partie fonctionnelle 5 est formée par une touche basculante sur le socle 6.

En variante, l'appareillage électrique pourrait présenter d'autres fonctions, telles que des fonctions de prise de courant, de prise de téléphone, de prise réseau ou encore de va-et-vient, auxquels cas la partie fonctionnelle de l'appareillage électrique 1 présenterait des formes différentes de celle représentée sur la figure 1.

Ici, le socle 6 est logé dans l'ouverture centrale 9 du cadre 7 du support d'appareillage 4. Pour son immobilisation dans cette ouverture centrale 9, le socle 6 présente, d'une part, un trottoir périphérique 6A qui prend appui sur deux rebords 8A s'étendant le long de deux côtés opposés du bord intérieur 8 du cadre 7, et d'autre part, des dents d'encliquetage 6B qui s'accrochent à des nervures d'accrochage 8B prévues en correspondance à l'arrière des rebords 8A.

Sur les figures 1 à 9, 10, et 11 à 13, on a représenté trois modes de réalisation de la plaque d'habillage 2 ; 102 de l'appareillage électrique 1. Cette plaque d'habillage 2 ; 102 permet de recouvrir esthétiquement le support d'appareillage 4, de manière que celui-ci ne soit pas visible à l'usager.

Dans ces trois modes, la plaque d'habillage 2 ; 102 est formée par la superposition d'une plaque arrière de montage 20, 30 ; 40, 50 ; 120 (en une ou deux parties) et d'une plaque avant de finition 10 ; 110.

La plaque arrière de montage présente une ouverture 22 ; 122 qui borde la partie fonctionnelle 5 de l'appareillage électrique 1, ici sa touche basculante, pour que l'usager puisse y accéder. Cette plaque arrière de montage est par ailleurs pourvue à l'arrière de moyens de montage 35 ; 125 sur le support d'appareillage 4.

La plaque avant de finition confère quant à elle un aspect esthétique à la plaque d'habillage 2 ; 102.

Selon une caractéristique particulièrement avantageuse de l'invention, ladite plaque arrière de montage 20, 30 ; 40, 50 ; 120 comporte en creux sur sa face avant un logement 24 ; 44 ; 124 qui loge complètement ladite plaque avant de finition 10 ; 110, de sorte que la face avant 11 ; 111 de ladite plaque avant de finition 10 ; 110 s'étend à l'affleurement ou légèrement en retrait de la face avant 21 ; 41 ; 121 de ladite plaque arrière de montage 20, 30 ; 40, 50 ; 120.

La plaque avant de finition 10 ; 110 présente, dans les trois modes de réalisation de l'invention représentés sur les figures 1 à 13, la forme d'un cadre plat 10A ; 110A de forme carrée.

Elle pourrait bien sûr présenter une forme autre, pour autant que cette forme corresponde à celle du logement 24 ; 44 ; 124 qui l'accueille.

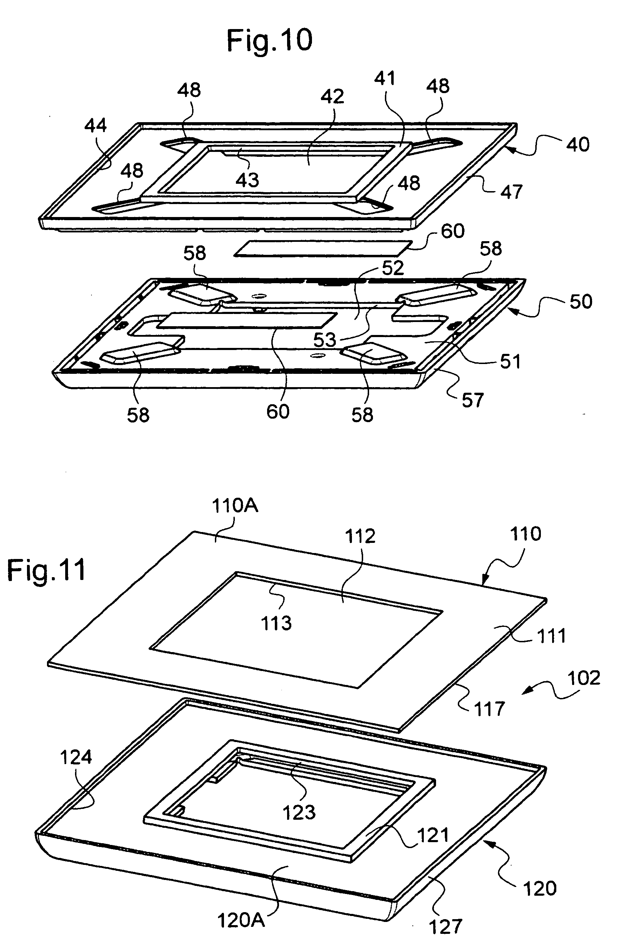

En l'espèce, comme le montrent plus particulièrement les figures 1 et 11, la plaque avant de finition 10 ; 110 présente ici une épaisseur constante, comprise entre 0,5 et 2 millimètres, préférentiellement comprise entre 1 et 1,5 millimètre. Elle est délimitée entre un bord extérieur 17 ; 117 carré et un bord intérieur 13 ; 113 également carré, qui définit une ouverture centrale 12 ; 112. Elle présente une face avant 11 ; 111 accessible à l'usager et une face arrière opposée positionnée contre le fond du logement 24 ; 124 qui l'accueille.

Cette plaque avant de finition 10 ; 110 est réalisée dans un matériau plus noble que celui ou ceux utilisé(s) pour réaliser la plaque arrière de montage 20, 30 ; 40, 50 ; 120. Par matériau plus noble, on entend matériau plus doux au toucher et/ou plus esthétique. A titre d'exemples non limitatifs, on pourra prévoir de réaliser la plaque avant de finition 10 ; 110 en bois, en cuir, en acier brossé, en métal tressé...

Préférentiellement, cette plaque avant de finition 10 ; 110 est réalisée d'une seule pièce, par exemple par découpe au laser d'une feuille de cuir ou d'un feuillard métallique.

En variante, elle pourrait présenter une structure bi-matière, avec une âme rigide recouverte, au moins en face avant, d'une peau esthétique accessible à l'usager. Elle pourrait en particulier comporter une âme métallique lui conférant un poids et une rigidité déterminés, et une peau en cuir ou en bois agréable à l'oeil et au toucher. Cette peau pourra plus précisément recouvrir soit l'ensemble de l'âme métallique, soit sa seule face avant, soit sa face avant et sa tranche.

Grâce à cette structure bi-matière, il est alors possible de fabriquer une grande variété de plaques d'habillage différentes, en s'assurant que ces plaques présentent toutes des caractéristiques géométriques et mécaniques homologues.

La plaque arrière de montage 20, 30 ; 40, 50 ; 120 peut présenter des formes variées. On décrira ici, dans les trois modes de réalisation de l'invention représentés sur les figures 1 à 13, trois formes particulières de cette plaque arrière de montage.

Dans le premier mode de réalisation de l'invention représenté sur les figures 1 à 9, la plaque arrière de montage est formée par la superposition d'une plaque intermédiaire 20 et d'une sous-plaque 30, assemblées l'une avec l'autre par soudure thermique.

La plaque d'habillage 2 est ainsi formée par la superposition d'une sous-plaque 30 qui comporte en face arrière les moyens de montage 35 sur le support d'appareillage 4, d'une plaque intermédiaire 20 qui est pourvue du logement 24 en creux, et d'une plaque avant de finition 10 qui est logée dans ce logement 24.

La plaque intermédiaire 20 présente ici la forme d'un cadre plat 20A de forme carrée. Elle est réalisée d'une seule pièce par moulage d'une matière synthétique ou métallique, telle que par exemple le zamak (alliage de zinc, d'aluminium, de magnésium et éventuellement de cuivre).

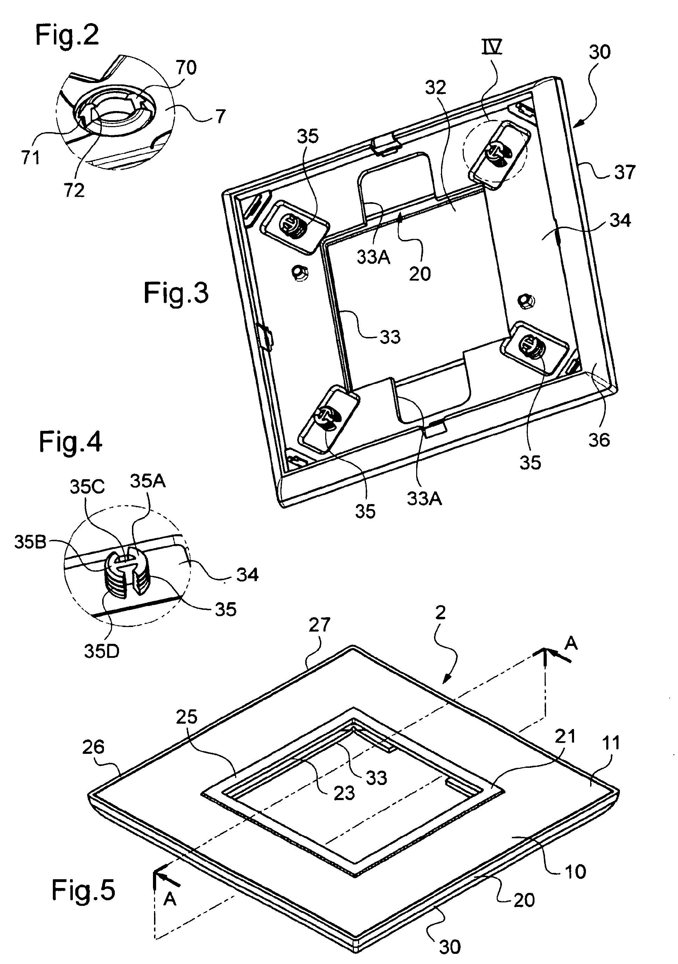

Comme le montrent plus particulièrement les figures 1 et 5, la plaque intermédiaire 20 est délimitée entre un bord extérieur 27 carré et un bord intérieur 23 également carré, qui délimite une ouverture centrale 22. Elle présente une face avant 21 et une face arrière opposée qui s'applique contre la sous-plaque 30.

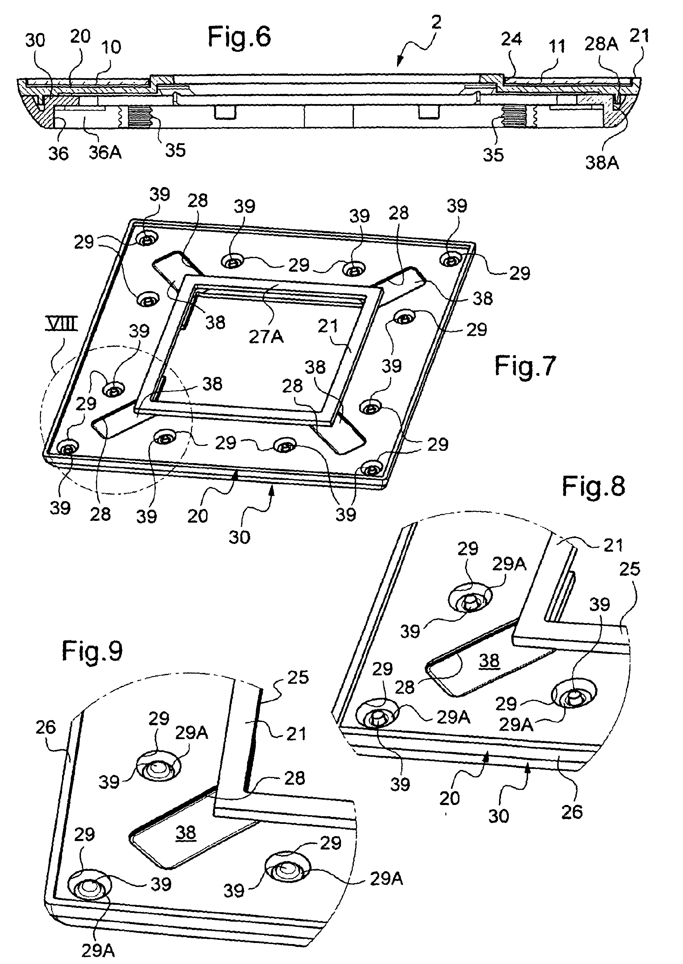

Le logement 24 s'étend en creux dans la face avant 21 de cette plaque intermédiaire de montage 20 et présente en négatif la forme de la plaque avant de finition 10. Le logement 24 présente donc ici une profondeur constante, égale à l'épaisseur de la plaque avant de finition 10, si bien que la face avant 11 de la plaque avant de finition 10 s'étend exactement à l'affleurement de la face avant 21 de la plaque intermédiaire 20 (voir figure 6).

Ainsi, les faces avant 11, 21 de la plaque intermédiaire 20 et de la plaque avant de finition 10 se raccordent continûment, pour ne laisser apparaître aucune discontinuité peu esthétique, peu agréable au toucher et propre à retenir les poussières et salissures.

En variante, on pourra prévoir que le logement présente une profondeur strictement supérieure à l'épaisseur de la plaque avant de finition, de manière que la face avant de la plaque avant de finition s'étende en retrait de la face avant de la plaque intermédiaire. Préférentiellement alors, la face avant de la plaque avant de finition s'étendra en retrait de moins d'un millimètre de la face avant de la plaque intermédiaire.

Quoi qu'il en soit, ici, le bord intérieur 23 de la plaque intermédiaire 20 présente des dimensions égales, au jeu près, à celles de la partie fonctionnelle 5 de l'appareillage électrique 1 (la touche basculante). De cette manière, la plaque intermédiaire 20 borde parfaitement cette partie fonctionnelle 5, sans faire apparaître d'interstice peu esthétique.

Le bord extérieur 27 présente quant à lui des dimensions supérieures à celles du support d'appareillage 4, de manière que la plaque d'habillage 2 recouvre l'intégralité de la face avant de ce dernier.

La plaque intermédiaire 20 comporte ici deux rebords périphériques intérieur et extérieur 25, 26 qui longent respectivement ses bords intérieur 23 et extérieur 27 et qui délimitent entre eux le logement 24 (voir figure 5). Ces deux rebords périphériques intérieur et extérieur 25, 26 cachent les tranches intérieure et extérieure de la plaque avant de finition 10, ce qui permet d'éviter que celle-ci ne soit malencontreusement accrochée, au bénéfice de sa résistance à l'arrachement hors du logement 24.

La plaque intermédiaire 20 est donc visible à l'usager au niveau de ces deux rebords périphériques intérieur 25 et extérieur 26. Avantageusement, ces deux rebords périphériques sont alors recouverts d'un revêtement qui confère un aspect esthétique à la plaque d'habillage 2. Ici, ce revêtement est réalisé en chrome. On pourra bien sûr prévoir qu'il soit réalisé autrement.

Préférentiellement, la plaque avant de finition 10 est logée dans le logement 24 de manière inamovible. Elle est à cet effet collée du côté de sa face arrière contre le fond du logement 24. On pourra en outre prévoir de coller ses bords extérieur 17 et intérieur 13 aux rebords périphériques 25, 26 de la plaque intermédiaire 20, de manière qu'elle ne se rétracte pas au cours du temps.

En variante, on pourrait également prévoir de fixer la plaque avant de finition dans le logement de la plaque intermédiaire par d'autres moyens de fixation inamovibles, tels que par exemple par soudage, par encliquetage ou par emboîtement.

Encore en variante, on pourra prévoir que la plaque avant de finition soit logée dans le logement de manière démontable, pour être interchangeable avec d'autres plaques avant de finition réalisées dans des matériaux différents. L'usager pourra ainsi changer à sa guise l'aspect de la plaque d'habillage pour l'adapter à ses goûts et aux décors de la pièce dans laquelle se trouve l'interrupteur. Les moyens de fixation de la plaque avant de finition dans le logement seront alors choisis pour être non permanents (colle peu adhérente, encliquetage, aimants, ...).

Comme le montrent les figures 1 et 3, la sous-plaque 30 présente quant à elle la forme d'un cadre plat 30A de forme carrée, avec une face avant 31 et une face arrière 34 opposée. Elle est ici réalisée d'une seule pièce par moulage en matière synthétique, par exemple en polycarbonate.

Cette sous-plaque 30 est délimitée entre un bord extérieur 37 carré et un bord intérieur 33 globalement carré, qui définit une ouverture centrale 32.

Le bord intérieur 33 présente des dimensions identiques à celles du bord intérieur 23 de la plaque intermédiaire 20. Il présente en outre, dans deux côtés opposés, deux encoches rectangulaires 33A qui prolongent l'ouverture centrale 32 en regard des deux perçages 7A du cadre 7 du support d'appareillage 4. De cette manière, les têtes des vis de fixation engagées au travers de ces perçages 7A n'interfèrent pas avec la sous-plaque 30.

Le bord extérieur 37 présente des dimensions identiques à celles du bord extérieur 27 de la plaque intermédiaire 20, de manière que ces bords extérieurs 27, 37 s'étendent dans le prolongement l'un de l'autre. On pourra d'ailleurs prévoir, par soucis esthétique, que le bord extérieur 37 de la sous-plaque 30 soit recouvert d'un revêtement identique à celui qui recouvre le bord extérieur 27 de la plaque intermédiaire 20.

Comme le montrent plus précisément les figures 3 et 6, la sous-plaque 30 porte en face arrière une nervure périphérique 36 qui longe son bord extérieur 37 et qui délimite ainsi, à l'arrière de la sous-plaque 30, un logement d'accueil 36A pour le support d'appareillage 4. Cette nervure périphérique 36 est ainsi adaptée à s'appliquer contre la paroi, tout autour du support d'appareillage 4, afin de cacher la tranche de ce dernier.

Les moyens de montage 35, 70 qui permettent de monter la sous-plaque 30 sur le support d'appareillage 4 apparaissent plus particulièrement sur les figures 1 à 4. Ils sont ici démontables, et sont plus particulièrement formés par des moyens d'encliquetage.

Ces moyens d'encliquetage comportent en l'espèce, à chaque coin du cadre 30A, un pion 35 qui s'étend en saillie à partir de la face arrière 34 de ce cadre 30A, perpendiculairement à celle-ci.

Comme le montre la figure 4, chaque pion 35 présente une paroi cylindrique fendue longitudinalement en deux parties 35A, 35B et renforcée par une nervure 35C qui relie ces deux parties 35A, 35B ensemble. La face externe de chaque pion 35 est crénelée pour définir des dents d'accroche 35D circulaires.

En correspondance, le support d'appareillage 4 comporte des plots 70, distincts du cadre 7 du support d'appareillage 4 et rapportés par encliquetage dans des ouvertures traversantes prévues à chaque coin de ce cadre 7.

Chaque plot 70 présente un corps tubulaire, avec une extrémité arrière (non visible sur les figures) fermée et bordée d'une couronne qui prend appui contre la face arrière du cadre 7, et une extrémité avant fendue longitudinalement et bordée d'une dent circulaire externe 71 qui s'accroche à la face avant du cadre 7 (voir figure 2).

Chaque plot 70 porte en outre, du côté de cette extrémité avant, une dent circulaire interne 72 qui s'accroche à l'une des dents d'accroche 35D de l'un des pions 35 de la sous-plaque 30.

La coopération de ces plots 70 et de ces pions 35 permet ainsi d'immobiliser la plaque d'habillage 2 sur le support d'appareillage 4.

Comme le montrent plus particulièrement les figures 1 et 7 à 9, la sous-plaque 30 comporte des moyens d'assemblage inamovibles avec la plaque intermédiaire 20.

La sous-plaque 30 et la plaque intermédiaire 20 comportent plus particulièrement des moyens de centrage 28, 38 et des moyens de fixation 29, 39 complémentaires.

Les moyens de centrage comportent, d'une part, quatre ouvertures 28 prévues dans la plaque intermédiaire 20, et, d'autre part, quatre protubérances 38 correspondantes situées en saillie de la face avant 31 de la sous-plaque 30 et logées dans les ouvertures 28 de la plaque intermédiaire 20.

Les ouvertures 28 sont plus précisément situées dans la paroi de fond du logement 24 de la plaque intermédiaire 20, à chaque coin du cadre 20A. Elles présentent ici des formes rectangulaires et s'étendent en longueur à partir du bord intérieur 23 du cadre 20A, suivant les diagonales de ce cadre 20A.

Les moyens de fixation comportent quant à eux, d'une part, douze perçages tubulaires 29 prévus dans la plaque intermédiaire 20, et, d'autre part, douze pions cylindriques 39 situés en saillie de la face avant 31 de la sous-plaque 30 et logés dans les perçages tubulaires 29 de la plaque intermédiaire 20.

Les perçages tubulaires 29 s'étendent plus précisément dans la paroi de fond du logement 24 de la plaque intermédiaire 20, à raison de trois perçages tubulaires 29 autour de chaque ouverture rectangulaire 28.

Chaque perçage tubulaire 29 présente avantageusement, du côté de la face arrière 34 de la sous-plaque 30, une réduction de section qui définit un épaulement 29A (voir figures 8 et 9).

Pour assembler la sous-plaque 30 avec la plaque intermédiaire 20, les pions cylindriques 39 et les protubérances 38 de la sous-plaque 30 sont engagés au travers des perçages tubulaires 29 et des ouvertures 28 de la plaque intermédiaire 20 (figure 8), puis les extrémités libres des pions cylindriques 39 sont déformées thermiquement pour prendre appui sur les épaulements 29A des perçages tubulaires 29 (figure 9).

Comme le montre plus particulièrement la figure 6, il est ici prévu des moyens de centrage complémentaires de la plaque intermédiaire 20 sur la sous-plaque 30. Ces moyens de centrage complémentaires comportent une nervure 28A qui s'étend sur la face arrière de la plaque intermédiaire 20, le long de son bord extérieur 27, et une rainure 38A qui s'étend en correspondance sur la face avant 31 de la sous-plaque 30 et dans laquelle se loge la nervure 28A de la plaque intermédiaire 20.

La présente invention n'est nullement limitée au mode de réalisation décrit et représenté, mais l'homme du métier saura y apporter toute variante conforme à son esprit.

En particulier dans le second mode de réalisation de l'invention représenté sur la figure 10, on pourra prévoir que les moyens d'assemblage inamovibles de la sous-plaque 50 avec la plaque intermédiaire 40 soient des moyens de collage.

Telles que représentées sur la figure 7, la plaque intermédiaire 40 et la sous-plaque 50 présentent des formes homologues à celles des plaque intermédiaire et sous-plaque représentées sur les figures 1 à 9, avec une face avant 41, 51 et une face arrière opposée, un bord extérieur 47, 57 et un bord intérieur 43, 53 globalement carrés, et une ouverture centrale 42, 52.

Le logement 44 en creux sur la face avant 41 de la plaque intermédiaire 40 est ici identique à celui de la plaque intermédiaire représentée sur les figures 1 à 9.

Les moyens de montage de la sous-plaque 50 sur le support d'appareillage sont également identiques à ceux de la sous-plaque représentée sur les figures 1 à 9.

Les moyens de centrage 48, 58 complémentaires de la sous-plaque 50 sur la plaque intermédiaire 40 sont eux aussi identiques à ceux de la sous-plaque représentée sur les figures 1 à 9.

En revanche, comme le montre la figure 10, les moyens de fixation inamovible de la sous-plaque 50 sur la plaque intermédiaire 40 diffèrent des moyens de fixation des plaque intermédiaire et sous-plaque représentées sur les figures 1 à 9.

Ces moyens de fixation comportent plus particulièrement deux bandes adhésives double face 60 interposées entre la plaque intermédiaire 40 et la sous-plaque 50, de part et d'autre de leurs ouvertures centrales 42, 52. Ces bandes adhésives double face 60 présentent ici des surfaces de collage et des coefficients d'adhérence tels que l'assemblage de la plaque intermédiaire 40 avec la sous-plaque 50 est inamovible.

En variante, ces moyens de fixation pourraient comporter un plus grand nombre de bandes adhésives. Ils pourraient également être formés par un simple cordon de colle déposé sur la sous-plaque ou sur la plaque intermédiaire, autour de son ouverture centrale.

Encore en variante, les moyens d'assemblage inamovibles de la sous-plaque avec la plaque intermédiaire pourront être d'autres sortes. En particulier ces moyens d'assemblage pourront être formés par des moyens d'encliquetage ou par des moyens d'emboîtement. On pourra également prévoir que la plaque intermédiaire et la sous-plaque soient surmoulées l'une sur l'autre.

Dans le troisième mode de réalisation de l'invention représenté sur les figures 11 à 13, la plaque arrière de montage 120 est formée d'une seule pièce.

La plaque d'habillage 102 est ainsi seulement formée par la superposition de la plaque avant de finition 110 et de cette plaque arrière de montage 120 monobloc.

Cette plaque arrière de montage 120 présente en l'espèce une forme homologue à celle de l'ensemble formé par la superposition de la sous-plaque et de la plaque intermédiaire représentées sur la figure 10.

Elle présente plus précisément ici la forme d'un cadre plat 120A de forme carrée, délimité entre un bord extérieur 127 carré et un bord intérieur 123 également carré, qui définit une ouverture centrale 122. Elle présente une face avant 121 et une face arrière opposée.

Cette plaque arrière de montage 120 comporte en face arrière les moyens de montage 125 sur le support d'appareillage et en face avant le logement 124 d'accueil de la plaque avant de finition 110.

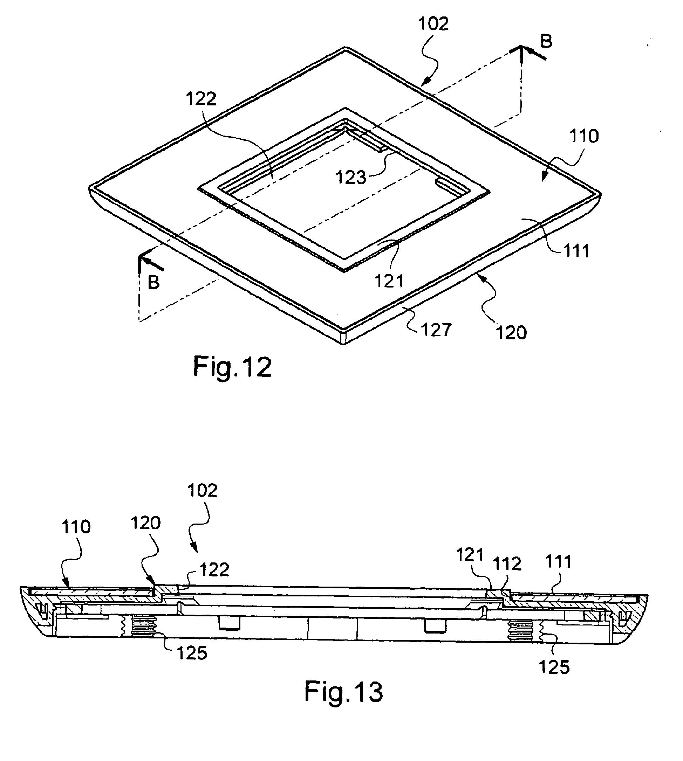

Comme le montre plus particulièrement la figure 13, les moyens de montage 125 de la plaque arrière de montage 120 sur le support d'appareillage sont ici identiques à ceux de la sous-plaque représentée sur les figures 1 à 9.

Le logement 124 présente, en négatif, une forme proche de celle de la plaque avant de finition 110. Sa paroi de fond est parfaitement plane et dépourvue d'ouverture de centrage. Sa profondeur est strictement supérieure à l'épaisseur de la plaque avant de finition 110, si bien que la face avant 111 de la plaque avant de finition 110 s'étend en retrait de la face avant 121 de la plaque arrière de montage 120 (voir figure 13).

La plaque arrière de montage 120 est réalisée d'une seule pièce par moulage d'une matière synthétique, telle que par exemple le polycarbonate. Ici, les parties visibles de cette plaque arrière de montage 120 sont avantageusement recouvertes d'un revêtement qui confère un aspect esthétique à la plaque d'habillage 102.

## Revendications

1. Plaque d'habillage (2 ; 102) pour appareillage électrique (1) qui présente au moins une ouverture (22, 32 ; 122) destinée à donner accès à au moins une partie fonctionnelle (5) de l'appareillage électrique (1) et qui est formée par la superposition d'une plaque arrière de montage (20, 30 ; 40, 50 ; 120) pourvue à l'arrière de moyens de montage (35 ; 123) sur un support d'appareillage (4), et d'une plaque avant de finition (10 ; 110) conférant un aspect esthétique à ladite plaque d'habillage (2 ; 102), dans laquelle ladite plaque arrière de montage (20, 30 ; 40, 50 ; 120) comporte en creux sur sa face avant un logement (24 ; 44 ; 124) qui loge complètement ladite plaque avant de finition (10 ; 110), de sorte que la face avant (11 ; 111) de ladite plaque avant de finition (10 ; 110) s'étend à l'affleurement ou légèrement en retrait de la face avant (21 ; 41 ; 121) de ladite plaque arrière de montage (20, 30 ; 40, 50 ; 120), **caractérisée en**_ ce que le logement (24 ; 44 ; 124) est délimité entre un rebord periphérique intérieur (25) bordant ladit ouverture_(22, 32 ; 122) et un rebord périphérigue extérieur (26).

2. Plaque d'habillage (102) selon la revendication précédente, dans laquelle la plaque arrière de montage (120) est formée d'une seule pièce.

3. Plaque d'habillage (2) selon la revendication 1, dans laquelle la plaque arrière de montage est formée par la superposition d'une plaque intermédiaire (20 ; 40) et d'une sous-plaque (30 ; 50), la plaque intermédiaire (20 ; 40) étant pourvue du logement (24 ; 44) en creux logeant ladite plaque avant de finition (10) et la sous-plaque (30 ; 50) comportant en face arrière lesdits moyens de montage (35).

4. Plaque d'habillage (2) selon la revendication précédente, dans laquelle la sous-plaque (30 ; 50) et la plaque intermédiaire (20 ; 40) sont solidarisées l'une à l'autre de manière inamovible.

5. Plaque d'habillage (2 ; 102) selon l'une des revendications précédentes, dans laquelle les rebords périphériques intérieur (25) et extérieur (26) sont recouverts d'un revêtement conférant un aspect esthétique à ladite plaque d'habillage (2 ; 102).

6. Plaque d'habillage (2 ; 102) selon la revendication précédente, dans laquelle ledit revêtement est réalisé en chrome.

7. Plaque d'habillage (2 ; 102) selon l'une des revendications précédentes, dans laquelle la plaque avant de finition (10 ; 110) et la plaque arrière de montage (20, 30 ; 40, 50 ; 120) sont solidarisées l'une à l'autre de manière inamovible.

8. Plaque d'habillage (2 ; 102) selon l'une des revendications 1 à 6, dans laquelle la plaque avant de finition (10 ; 110) et la plaque arrière de montage (20, 30 ; 40, 50 ; 120) sont solidarisées l'une à l'autre de manière démontable.

9. Plaque d'habillage (2 ; 102) selon l'une des revendications précédentes, dans laquelle la plaque avant de finition (10 ; 110) présente une épaisseur comprise entre 0,5 et 2 millimètres, préférentiellement comprise entre 1 et 1,5 millimètre.

10. Plaque d'habillage (2 ; 102) selon l'une des revendications précédentes, dans laquelle la plaque avant de finition (10 ; 110) comporte une âme rigide et une peau qui recouvre au moins la face avant de l'âme rigide pour conférer un aspect esthétique à ladite plaque d'habillage (2 ; 102).

11. Plaque d'habillage (2 ; 102) selon l'une des revendications précédentes, dans laquelle la plaque avant de finition (10 ; 110) et la plaque arrière de montage (20, 30 ; 40, 50 ; 120) sont réalisées dans des matières différentes.

12. Plaque d'habillage (2 ; 102) selon l'une des revendications précédentes, dans laquelle la plaque arrière de montage (20, 30 ; 40, 50 ; 120) est réalisée par une ou plusieurs opérations de moulage.

13. Plaque d'habillage (2 ; 102) selon l'une des revendications précédentes, dans laquelle la plaque avant de finition (10 ; 110) est réalisée par découpe au laser.

14. Appareillage électrique (1) comportant un support d'appareillage (4) qui supporte un mécanisme d'appareillage (3) présentant en face avant au moins une partie fonctionnelle (5), **caractérisé en ce qu'**il comporte une plaque d'habillage (2 ; 102) selon l'une des revendications précédentes, dont l'ouverture (22, 32 ; 122) borde la partie fonctionnelle (5) du mécanisme d'appareillage (3) et dont les moyens de montage (35 ; 125) de la plaque arrière de montage (20, 30 ; 40, 50 ; 120) sont montés dans des aménagements (70) du support d'appareillage (4).

## Claims

1. Cover plate (2; 102) for electrical apparatus (1) which includes at least one opening (22, 32; 122) intended to provide access to at least one functional part (5) of the electrical apparatus (1) and which is formed by superimposing a rear mounting plate (20, 30; 40, 50; 120) fitted at the back with means (35; 123) for mounting on an apparatus support (4) and a front finish plate (10; 110) giving said cover plate (2; 102) an aesthetic appearance, wherein said rear mounting plate (20, 30; 40, 50; 120) includes on its front side a recessed housing (24; 44; 124) which completely houses said front finish plate (10; 110), such that the front side (11; 111) of said front finish plate (10; 110) extends flush with or is slightly back from the front side (21; 41; 121) of said rear mounting plate (20, 30; 40, 50; 120), **characterized in that** the housing (24; 44; 124) is delimited between an inner peripheral edge (25) bordering said opening (22, 32; 122) and an outer peripheral edge (26).

2. Cover plate (102) according to the preceding claim, wherein the rear mounting plate (120) is formed from a single piece.

3. Cover plate (2) according to claim 1, wherein the rear mounting plate is formed by superimposing an intermediate plate (20; 40) and a sub-plate (30; 50), the intermediate plate (20; 40) being equipped with a recessed housing (24; 44) to house said front finish plate (10) and the sub-plate (30; 50) including said mounting means (35) on the rear side.

4. Cover plate (2) according to the preceding claim, wherein the sub-plate (30; 50) and the intermediate plate (20; 40) are undetachably fastened to each other.

5. Cover plate (2; 102) according to one of the preceding claims, wherein the inner and outer peripheral edges (25, 26) are covered by a coating giving said cover plate (2; 102) an aesthetic appearance.

6. Cover plate (2; 102) according to the preceding claim, wherein said coating is made from chromium.

7. Cover plate (2; 102) according to one of the preceding claims, wherein the front finish plate (10; 110) and the rear mounting plate (20, 30; 40, 50; 120) are undetachably fastened to each other.

8. Cover plate (2; 102) according to one of claims 1 to 6, wherein the front finish plate (10; 110) and the rear mounting plate (20, 30; 40, 50; 120) are detachably fastened to each other.

9. Cover plate (2; 102) according to one of the preceding claims, wherein the front finish plate (10; 110) has a thickness of between 0.5 and 2 millimeters, preferably between 1 and 1.5 millimeters.

10. Cover plate (2; 102) according to one of the preceding claims, wherein the front finish plate (10; 110) includes a rigid core and a skin which covers at least the front side of the rigid core to give said cover plate (2; 102) an aesthetic appearance.

11. Cover plate (2; 102) according to one of the preceding claims, wherein the front finish plate (10; 110) and the rear mounting plate (20, 30; 40, 50; 120) are made from different materials.

12. Cover plate (2; 102) according to one of the preceding claims, wherein the rear mounting plate (20, 30; 40, 50; 120) is made by one or more moulding operations.

13. Cover plate (2; 102) according to one of the preceding claims, wherein the front finish plate (10; 110) is made by laser cutting.

14. Electrical apparatus (1) including an apparatus support (4) supporting an apparatus mechanism (3) with on the front side at least one functional part (5), **characterized in that** the electrical apparatus (1) includes a cover plate (2; 102) according to any one of the preceding claims, whose opening (22, 32; 122) borders the functional part (5) of the apparatus mechanism (3) and whose means (35; 125) for mounting the rear mounting plate (20, 30; 40, 50; 120) are mounted in arrangements (70) of the apparatus support (4).

## Patentansprüche

1. Abdeckplatte (2, 102) für ein elektrisches Gerät (1), mit mindestens einer Öffnung (22, 32, 122) für den Zugang zu mindestens einem Funktionsbereich (5) des elektrischen Geräts (1), die durch das Übereinanderlagern einer hinteren Montageplatte (20, 30, 40, 50, 120), die auf der Rückseite von Montagemitteln (35, 123) auf einer Gerätehalterung (4) vorgesehen ist, und einer vorderen Abschlussplatte (10, 110), die der Abdeckplatte (2, 102) einen angenehmen ästhetischen Aspekt verleiht, gebildet ist, bei der die hintere Montageplatte (20, 30, 40, 50, 120) in einer Vertiefung ihrer Vorderseite eine Aufnahme (24, 44, 124) umfasst, die die vordere Abschlussplatte (10, 110) ganz aufnimmt, sodass sich die Vorderseite (11, 111) der vorderen Abschlussplatte (10, 110) bündig mit oder leicht zurückgesetzt zur Vorderseite (21, 41, 121) der hinteren Montageplatte (20, 30, 40, 50, 120) erstreckt, **dadurch gekennzeichnet, dass** die Aufnahme (24, 44, 124) zwischen einem inneren peripheren Rand (25), der die Öffnung (22, 32, 122) umgibt, und einem äußeren peripheren Rand (26) abgegrenzt ist.

2. Abdeckplatte (102) nach vorausgehendem Anspruch, bei der die hintere Montageplatte (120) aus einem einzigen Teil gebildet ist.

3. Abdeckplatte (2) nach Anspruch 1, bei der die hintere Montageplatte durch Überlagern einer Zwischenplatte (20, 40) und einer Unterplatte (30, 50) gebildet wird, wobei die Zwischenplatte (20, 40) in einer Vertiefung mit der Aufnahme (24, 44) versehen ist, welche die vordere Abschlussplatte (10) und die Unterplatte (30, 50) aufnimmt, die auf ihrer Rückseite die Montagemittel (35) aufweist.

4. Abdeckplatte (2) nach vorausgehendem Anspruch, bei der die Unterplatte (30, 50) und die Zwischenplatte (20, 40) nicht voneinander trennbar miteinander verbunden sind.

5. Abdeckplatte (2, 102) nach einem der vorausgehenden Ansprüche, bei der der innere (25) und äußere (26) periphere Rand mit einer Beschichtung überzogen sind, die der Abdeckplatte (2, 102) einen angenehmen ästhetischen Aspekt verleiht.

6. Abdeckplatte (2, 102) nach vorausgehendem Anspruch, bei der die Beschichtung aus Chrom ist.

7. Abdeckplatte (2, 102) nach einem der vorausgehenden Ansprüche, bei der die vordere Abschlussplatte (10, 110) und die hintere Montageplatte (20, 30, 40, 50, 120) nicht voneinander trennbar miteinander verbunden sind.

8. Abdeckplatte (2, 102) nach einem der Ansprüche 1 bis 6, bei der die vordere Abschlussplatte (10, 110) und die hintere Montageplatte (20, 30, 40, 50, 120) demontierbar miteinander verbunden sind.

9. Abdeckplatte (2, 102) nach einem der vorausgehenden Ansprüche, bei der die vordere Abschlussplatte (10, 110) eine Dicke zwischen 0,5 und 2 Millimeter, vorzugsweise zwischen 1 und 1,5 Millimeter aufweist.

10. Abdeckplatte (2, 102) nach einem der vorausgehenden Ansprüche, bei der die vordere Abschlussplatte (10, 110) eine starre Innenschicht und eine Schale umfasst, die mindestens die Vorderseite der starren Innenschicht abdeckt, um der Abdeckplatte (2, 102) einen angenehmen ästhetischen Aspekt zu verleihen.

11. Abdeckplatte (2, 102) nach einem der vorausgehenden Ansprüche, bei der die vordere Abschlussplatte (10, 110) und die hintere Montageplatte (20, 30, 40, 50, 120) aus unterschiedlichen Materialien hergestellt sind.

12. Abdeckplatte (2, 102) nach einem der vorausgehenden Ansprüche, bei der die hintere Montageplatte (20, 30, 40, 50, 120) durch einen oder mehrere Gussvorgänge hergestellt ist.

13. Abdeckplatte (2, 102) nach einem der vorausgehenden Ansprüche, bei der die vordere Abschlussplatte (10, 110) durch Lasertrimmen hergestellt ist.

14. Elektrische Gerätschaft (1) mit einer Gerätehalterung (4), die einen Gerätemechanismus (3) trägt, der auf der Vorderseite mindestens einen Funktionsbereich (5) aufweist, **dadurch gekennzeichnet, dass** sie eine Abdeckplatte (2, 102) nach einem der vorausgehenden Ansprüche umfasst, deren Öffnung (22, 32, 122) den Funktionsbereich (5) des Gerätemechanismus (3) umrandet und bei der die Montagemittel (35, 125) der hinteren Montageplatte (20, 30, 40, 50, 120) in Anordnungen (70) der Gerätehalterung (4) montiert sind.
